# EUROPÄISCHE PATENTANMELDUNG

(11) **EP 1 104 228 A2**
(43) Veröffentlichungstag der Anmeldung: **30.05.2001**
(21) Anmeldenummer: 00123905.2
(22) Anmeldetag: 03.11.2000
(51) Int. Cl.: H05K 5/00

(54) **Kunststoffgehäuse zur Aufnahme einer Baugruppe mit elektrischen und elektronischen Bauteilen auf einer Leiterplatte**

(30) Priorität: 25.11.1999 DE 19956675
(71) Anmelder: DaimlerChrysler AG, 70567 Stuttgart (DE)
(72) Erfinder: Baur, Richard, 85276 Pfaffenhofen (DE); Fendt, Günter, 86529 Schrobenhausen (DE); Wöhrl, Alfons, 86529 Schrobenhausen (DE); Wörle, Engelbert, 86556 Kübach (DE)
(74) Vertreter: Maute, Hans-Jürgen, Dipl.-Ing.

(57) **Zusammenfassung**

**2.1**. Metallgehäuse werden zunehmend durch Kunststoffgehäuse ersetzt, bei denen sich bei einer Absenkung der Temperatur aufgrund von Kondensation aus der Luftfeuchte Feuchtigkeit auf den im Gehäuse angeordneten elektrischen und elektronischen Bauteilen niederschlägt. Zum Schutz vor Korrosion werden in vielen Fällen elektrische Baugruppen mit einer Schutzlackschicht versiegelt. Diese Maßnahme weist den Nachteil auf, dass elektronische Bauteile zum Beispiel zur Aktualisierung einer Software oder zur Untersuchung des Langzeitverhaltens nicht mehr zugänglich sind.
**2.2.** In einem Kunststoffgehäuse sind innerhalb des Gehäuses eine oder mehrere ausgedehnte Metallflächen zur Kondensation von Luftfeuchtigkeit vorhanden.
**2.3.** Die Erfindung eignet sich für Kunststoffgehäuse um Baugruppen aus elektrischen und elektronischen Bauelementen, wie sie bei Fahrzeugen, beispielsweise als Steuergeräte, verwendet werden.

## Beschreibung

Die Erfindung betrifft ein Kunststoffgehäuse zur Aufnahme einer Baugruppe mit elektrischen und elektronischen Bauteilen auf einer Leiterplatte nach dem Oberbegriff des Patentanspruchs 1.

Aufgrund des geringeren Gewichts und der günstigeren Herstellweise werden insbesondere in Kraftfahrzeugen Metallgehäuse zunehmend durch Kunststoffgehäuse ersetzt. Kunststoffgehäuse sind zwar üblicherweise spritzwassergeschützt, aber nicht hermetisch dicht verschlossen, so dass sich Luftfeuchtigkeit im Innern eines solchen Kunststoffgehäuses befindet. Dies hat den Nachteil, daß sich bei einer Absenkung der Temperatur aufgrund von Kondensation aus der Luftfeuchte Feuchtigkeit auf den im Gehäuse angeordneten metallischen und damit elektrischen (und elektronischen) Bauteilen niederschlägt und nicht auf der Innenseite der Gehäuseaußenwand.

Damit diese Feuchtigkeit keine Korrosion verursacht und nicht zu Kriechströmen oder Kurzschlüssen führt, werden in vielen Fällen die elektrischen Bauteile mit einer Schutzlackschicht versiegelt. Diese Maßnahme weist den Nachteil auf; dass die elektronischen Bauteile zum Beispiel zur Aktualisierung einer Software oder zur Untersuchung des Langzeitverhaltens nicht mehr zugänglich sind und deshalb häufig das gesamte Steuergerät ausgetauscht werden muss, was mit hohen Kosten verbunden ist.

Es ist deshalb Aufgabe der Erfindung, ein (Kunststoff-) Gehäuse anzugeben, bei dem durch konstruktive Maßnahmen bei Temperaturschwankungen die Kondensation der Luftfeuchte auf den elektrischen und elektronischen Bauteilen vermieden wird.

Diese Aufgabe wird durch die kennzeichnenden Merkmale des Anspruchs 1 gelöst.

Die Vorteile der Erfindung liegen darin, dass die elektrischen Bauteile innerhalb des Gehäuses weiterhin frei zugänglich sind und somit Änderungen vorgenommen werden können. Beim Recycling können Metall- und Kunststoffteile leicht separiert werden.

Die Erfindung eignet sich für Kunststoffgehäuse um Baugruppen aus elektrischen und elektronischen Bauelementen, wie sie bei Fahrzeugen, beispielsweise als Steuergeräte, verwendet werden.

Vorteilhafte Ausgestaltungen des Gegenstands des Anspruchs 1 sind in den Unteransprüchen angegeben.

Die Erfindung wird nun anhand eines Ausführungsbeispiels unter Zuhilfenahme der Zeichnung erläutert. Es zeigen
- Fig. 1:: ein erstes Kunststoffgehäuse um eine Baugruppe aus elektrischen und elektronischen Bauelementen, bei dem sich Metallflächen auf den elektrischen oder elektronischen Bauelementen befinden und
- Fig. 2:: ein zweites Kunststoffgehäuse um eine Baugruppe aus elektrischen und elektronischen Bauelementen, bei dem sich Metallflächen im Bodenbereich befinden.

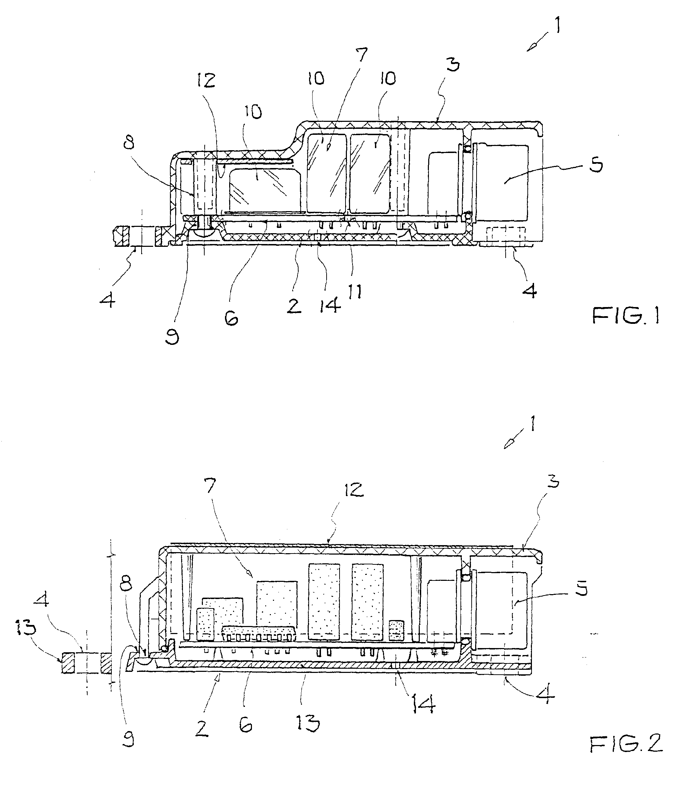

Die **Fig. 1** und **2** zeigen jeweils ein spritzwassergeschütztes Kunststoffgehäuse **1** mit einem Gehäuseboden **2** aus Metall oder (glasfaserverstärktem) Kunststoff und einer Abdeckung (Gehäusedeckel) **3** aus Kunststoff. Zur Befestigung des Kunststoffgehäuses **1**, beispielsweise mittels Schrauben oder Nieten in einem Fahrzeug, sind an die Abdeckung **3** Befestigungsösen **4** angeformt. Weiterhin ist in die Abdeckung **3** eine Steckereinheit **5** integriert. Im Innern des Kunststoffgehäuses **1** ist eine Leiterplatte **6** mit einer Baugruppe aus elektrischen und elektronischen Bauelementen **7** angeordnet. Zapfen **8** dienen in Verbindung mit im Gehäuseboden **2** befindlichen Buchsen **9** dazu, Gehäuseboden **2** und Abdeckung **3** miteinander zu verbinden, indem die durch die Buchsen **9** hindurch ragenden Zapfen **8** beispielsweise mittels Ultraschall zuerst erwärmt und anschließend plattgedrückt werden. Die Zapfen **8** können auch dazu verwendet werden, als Justiermittel eine genaue Ausrichtung der Leiterplatte **6** innerhalb des Gehäuses **1** zu gewährleisten.

Bei normaler Umgebungstemperatur ist die Luft in der Lage, mehr Feuchtigkeit in Form von Wasserdampf aufzunehmen, als dies bei niedriger Umgebungstemperatur der Fall ist. Bei sich abkühlender Umgebungstemperatur wird der Wasserdampf übersättigt und kondensiert. Aus der übersättigten Luftfeuchte fällt Wasser aus, das sich als Kondensat in Form eines Flüssigkeitsfilms oder tropfenförmig niederschlägt, und zwar verstärkt an solchen Materialien, die sich vergleichsweise schnell der veränderten Umgebungstemperatur anpassen, die also relativ schnell abkühlen. Materialien, die sich schnell einer veränderten Umgebungstemperatur anpassenden, sind beispielsweise Metalle und andere Stoffe, die eine hohe Wärmeleitfähigkeit aufweisen.

Daraus ergibt sich das Problem, dass sich Wasserdampf aus feuchter Luft als Kondensat hauptsächlich an Metallteilen von Leiterplatte **6** oder Bauelementen **7** niederschlägt und dort zu Kriechströmen, Kurzschlüssen oder Überschlägen führen kann. Zudem setzt an befeuchteten Stellen verstärkt Korrosion ein, die zum Ausfall der Baugruppe führen können. Um auf ein Metallgehäuse oder eine Beschichtung der Leiterplatte **6** und der Bauelemente **7** mittels Schutzlack verzichten zu können, werden im Innern des Gehäuses **1** ausgedehnte Metallflächen angeordnet, so dass die Luftfeuchtigkeit verstärkt an diesen Metallflächen kondensiert und empfindliche elektronische Bauelemente **7** vom Kondensat verschont bleiben.

Beim Gehäuse **1** der **Fig. 1** sind diese Metallflächen dadurch realisiert, dass bestimmte, gegen Kondensat unempfindliche Bauelemente **7** eine metallene Umhüllung **10** aufweisen und nicht, wie dies normalerweise der Fall ist, mit einer Kunststoffummantelung versehen sind. Als geeignete Bauelemente **7**, an denen sich bei Abkühlung der Umgebungstemperatur gewollt und verstärkt Kondensat ansammelt, kommen beispielsweise Relais, Sensoren, Batterien, Akkus oder Kondensatoren mit Metallgehäuse in Frage. Durch Bohrungen **11** in der Leiterplatte **6** und Bohrungen **14** im Gehäuseboden **2** wird dafür gesorgt, dass bei Abkühlung an den metallenen Umhüllungen **10** sich ansammelndes und abfließendes Kondensat aus dem Gehäuse **1** gelangt.

Eine zweite Möglichkeit zur Realisierung von Metallflächen besteht darin, die Innenseite der Abdeckung **3** mit Metall zu bedampfen oder dort eine metallene Haube oder ein Einlegeteil **12** aus Metall zu plazieren, dessen Kontur ungefähr oder genau mit dem des Gehäusedeckels **3** übereinstimmt. Auch hier dienen Bohrungen **14** dazu, das sich bei Abkühlung bildende Kondensat abzuführen. Diese zweite Möglichkeit kann bei Bedarf mit den metallenen Umhüllungen **10** kombiniert werden und hat den Vorteil, auch zur elektromagnetischen Abschirmung der Baugruppe **7** zu dienen.

Ohne weitere Maßnahmen schlägt sich das beim Abkühlen der Umgebung entstehende Kondensat an den metallenen Umhüllungen **10**, an der metallisierten Innenseite der Abdeckung **3** bzw. am metallenen Einlegeteil **12**, je nach Ausführung, als geschlossener Wasserfilm (Filmkondensation) nieder. Die Feuchtigkeit verbleibt somit innerhalb des Kunststoffgehäuses 1 und verdunstet oder verdampft bei sich erwärmender Umgebung wieder. Bei erneuter Abkühlung ist erhöhte Kondensatbildung die Folge. Daher empfiehlt es sich, das Kondensat aus dem Inneren des Gehäuses 1 zu entfernen.

Um das Kondensat durch Bohrungen **14** nach außen ableiten zu können, muss der geschlossene Wasserfilm aufgelöst und die Feuchtigkeit in Tropfenform gebracht werden. Diese Tropfenbildung kann durch Reduktion der Oberflächenspannung des Wassers erzwungen werden, wozu ein wasserabweisender Film, der beispielsweise durch Einölen der metallenen Flächen hergestellt wird, dient. Auf Grund ihrer Masse und der verringerten Oberflächenrauigkeit der metallenen Flächen laufen die Wassertropfen leicht von den Flächen ab und können durch Rillen oder kleine Erhebungen gezielt den Bohrungen **14** zugeführt werden.

Eine weitere Möglichkeit, die bei Bedarf mit den beiden bereits beschriebenen kombiniert werden kann, ist in **Fig. 2** dargestellt. Dort weist das Gehäuse **1** ausgedehnte Metallflächen in Form eines metallenen Gehäusebodens **2** auf, der zudem als Wärmesenke zur Kühlung der Baugruppe dient. Diese Ausgestaltung der Erfindung ist insbesondere dann vorteilhaft, wenn der Gehäuseboden **2** nicht waagerecht, sondern in einem Winkel zur Waagerechten verläuft. Hier kann die Tropfenbildung ebenfalls durch Reduktion der Oberflächenspannung des Wassers, beispielsweise durch Einölen des Gehäusebodens **2**, erzwungen werden und das Kondenswasser mittels Rillen oder Erhebungen gelenkt und durch Bohrungen **14** aus dem Gehäuse **1** geleitet werden.

Diese Ausführung kann bei einem nicht metallenen Gehäuseboden **2** auch leicht abgewandelt werden, indem eine zusätzliche metallene Bodenplatte **13** in der Nähe des Gehäusebodens **2** in das Gehäuse **1** eingelegt wird. Auch hier kann die Tropfenbildung durch Reduktion der Oberflächenspannung des Wassers, beispielsweise durch Einölen des Gehäusebodens **2**, erzwungen werden und das Kondenswasser mittels Rillen oder Erhebungen gelenkt und durch Bohrungen **14** aus dem Gehäuse **1** geleitet werden.

## Patentansprüche

1. Kunststoffgehäuse (1) zur Aufnahme einer Baugruppe mit elektrischen und elektronischen Bauteilen (7) auf einer Leiterplatte (6), bestehend aus einem Gehäuseboden (2) und einer Abdeckung (3), **dadurch gekennzeichnet, dass** innerhalb des Gehäuses (1) eine oder mehrere ausgedehnte Metallflächen (2, 10, 12, 13) zur Kondensation von Luftfeuchtigkeit angeordnet sind.

2. Kunststoffgehäuse (1) nach Anspruch 1, dadurch gekennzeichnet, dass die Metallflächen in Form von metallenen Umhüllungen der Bauteile (7) realisiert sind.

3. Kunststoffgehäuse (1) nach Anspruch 1 oder 2, dadurch gekennzeichnet, dass die Metallflächen durch Metallisierung der Innenseite des Kunststoffgehäuses (1) ausgeführt sind.

4. Kunststoffgehäuse (1) nach einem der Ansprüche 1 bis 3, dadurch gekennzeichnet, dass die Metallflächen durch ein metallenes Einlegeteil (12) verwirklicht sind.

5. Kunststoffgehäuse (1) nach einem der Ansprüche 1 bis 4, dadurch gekennzeichnet, dass das Kunststoffgehäuse (1) einen metallenen Gehäuseboden (2) aufweist, der als Metallfläche dient.

6. Kunststoffgehäuse (1) nach einem der Ansprüche 1 bis 5, dadurch gekennzeichnet, dass die Metallflächen in Form einer zusätzlichen metallenen Bodenplatte (13) vorhanden sind.

7. Kunststoffgehäuse (1) nach einem der Ansprüche 1 bis 6, dadurch gekennzeichnet, dass die Metallflächen (2, 10, 12, 13) zur erzwungenen Tropfenbildung einen wasserabweisenden Film aufweisen.

8. Kunststoffgehäuse (1) nach einem der Ansprüche 1 bis 7, dadurch gekennzeichnet, dass die Metallflächen (2, 10, 12, 13) Rillen oder Erhebungen zur gelenkten Ableitung des Kondenswassers aufweisen.

9. Kunststoffgehäuse (1) nach einem der Ansprüche 1 bis 8, dadurch gekennzeichnet, dass das Kunststoffgehäuse (1) zur Ableitung des Kondenswassers Bohrungen (11) in der Leiterplatte (6) aufweist.

10. Kunststoffgehäuse (1) nach einem der Ansprüche 1 bis 9, dadurch gekennzeichnet, dass das Kunststoffgehäuse (1) zur Ableitung des Kondenswassers Bohrungen (14) im Gehäuseboden (2) aufweist.
